# EUROPÄISCHE PATENTANMELDUNG

(11) **EP 0 787 585 A1**
(43) Veröffentlichungstag der Anmeldung: **06.08.1997**
(21) Anmeldenummer: 96119513.8
(22) Anmeldetag: 05.12.1996
(51) Int. Cl.: B41F 15/44

(54) **Rakel für den Siebdruck von elektrischen Elementen und Strukturen**

(30) Priorität: 03.02.1996 DE 29601855 U
(71) Anmelder: ROBERT BOSCH GMBH, 70442 Stuttgart (DE)
(72) Erfinder: Sabotke, Jens, Dr., 31139 Hildesheim (DE); Hauschild, Frank-Dieter, 31134 Hildesheim (DE); Graen, Ansgar, 31199 Diekholzen (DE); Fricke, Klaus, 31171 Nordstemmen (DE)

(57) **Zusammenfassung**

Um eine Rakel (10) für den Siebdruck von elektrischen Elementen und Strukturen auf einer Trägerplatte (20) mit Unebenheiten (30) derart zu verbessern, daß diese bei einfachster Herstellung zum Drucken auf Trägerplatten mit unterschiedlichster Anordnung der Unebenheiten eingesetzt werden kann, wird vorgeschlagen, die Rakel (10) elastisch auszubilden und auf einer der Trägerplatte (20) zugewandten Seite der Rakel einen oder mehrere Schlitze (13) zur Teilung der Rakel in mehrere Rakelteile (14) vorzusehen. Vorteilhaft kann der Abstand der Schlitze jeweils auf die Lage und Breite der auf der Trägerplatte angeordneten Unebenheiten (30) angepaßt werden.

## Beschreibung

### Stand der Technik

Die Erfindung betrifft ein Rakel für den Siebdruck von elektrischen Elementen und Strukturen auf einer Trägerplatte mit Unebenheiten.

Es ist allgemein bekannt, in der sogenannten Dickfilmtechnik mit Hilfe des Siebdrucks Strukturen, wie Leiterbahnen und Brücken sowie elektrische Elemente, wie Widerstände, auf Leiterplatten als Trägerplatten aufzubringen. Allgemein besteht in der Halbleitertechnologie die Forderung nach kleineren Strukturgrößen in der Aufbau- und Verbindungstechnik und damit in der Entwicklung feinerer Leiterbahnen und geringerer Abstände.

Hierbei werden die unterschiedlichen elektrischen Elemente und Strukturen gewöhnlich in mehreren aufeinanderfolgenden Schritten auf die Trägerplatte aufgebracht. So werden beispielsweise zunächst Halbleiterbauelemente und andere Schaltelemente auf der Trägerplatte angeordnet und im Anschluß daran Leiterbahnen und Brücken zwischen diesen Schaltelementen mittels Siebdrucktechnik auf die Trägerplatte aufgebracht. Dabei werden die zunächst aufgebrachten Schaltelemente beispielsweise mit Metallmasken abgedeckt, so daß Leiterbahnen ausschließlich zwischen den einzelnen Schaltelementen aufgedruckt werden.

Diese mit den Metallmasken abgedeckten Schaltelemente stellen Unebenheiten und Hindernisse auf der Trägerplatte dar, die den Druckvorgang mittels Siebdrucktechnik erschweren. Die Siebdruckvorrichtung muß daher auf die Unebenheiten auf der Trägerplatte angepaßt sein.

Eine Möglichkeit ist es nun, das Drucksieb auf die Unebenheiten anzupassen. Ein derartiges Drucksieb geht beispielsweise aus der DE-40 15 292 A1 hervor.

Darüber hinaus kann aber auch das Rakel auf die Unebenheiten auf der Trägerplatte angepaßt sein.

Aus diesem Grunde werden gewöhnlich Rakel verwendet, die aus mehreren Teilen bestehen, wobei im Rakel Aussparungen vorgesehen sind, derart, daß die Unebenheiten ausgenommen sind, so daß das Rakel an der Stelle der Unebenheiten die Trägerplatte nicht berührt. Der Materialauftrag, d.h. der Auftrag der Leiterbahnen und dergleichen, erfolgt daher nur spurweise seitlich neben den Unebenheiten.

Nachteilig bei diesen Rakeln ist es nun, daß für unterschiedliche Tägerplatten mit unterschiedlicher Bestückung unterschiedliche Rakelgummis vorgesehen sein müssen, da die Aussparungen in den Rakeln und mithin die Rakel selbst jeweils auf die auf der Trägerplatte angeordneten Schaltelemente, d.h. Unebenheiten angepaßt werden müssen. Dies erfordert eine aufwendige Bearbeitung oder Herstellung der Rakel, die eine Steigerung der Kosten zur Folge hat. Darüber hinaus muß ein Materialauftrag mit derartigen Rakeln immer in wenigstens zwei Druckrichtungen erfolgen, da aufgrund der Aussparung jeweils in eine Richtung kein Materialauftrag erfolgen kann, selbst wenn die Unebenheit in diese Richtung begrenzt ist.

Der Erfindung liegt daher die Aufgabe zugrunde, ein Rakel der gattungsgemäßen Art derart zu verbessern, daß dieses bei einfachster Herstellung zum Drucken auf Trägerplatten mit unterschiedlichster Anordnung der Unebenheiten eingesetzt werden kann.

Diese Aufgabe wird bei einem Rakel der eingangs beschriebenen Art erfindungsgemäß dadurch gelöst, daß das Rakel elastisch ausgebildet ist und auf seiner der Trägerplatte zugewandten Seite einen oder mehrere Schlitze zur Teilung des Rakels in mehrere Rakelteile aufweist.

Die elastische Ausbildung des Rakels und die Anordnung eines oder mehrerer Schlitze auf seiner der Trägerplatte zugewandten Seite hat den besonders großen Vorteil, daß die Rakelteile beim Überqueren von unterschiedlichen Unebenheiten unabhängig voneinander von der Trägerplatte wegschwenken und nach Überqueren der Unebenheiten in ihre Ausgangsposition zurückkehren. Hierdurch ist es möglich, das Rakel bei einer beliebigen Anordnung und Verteilung der Unebenheiten auf der Trägerplatte einzusetzen, da immer nur der Rakelteil wegschwenkt, der gerade eine Unebenheit überquert, wohingegen der Rakelteil, der nicht auf eine Unebenheit trifft, auf der Trägerplatte aufliegt und das aufzutragende Material, beispielsweise eine Leiterbahn, auf die Trägerplatte aufträgt.

Besonders vorteilhaft ist es auch, daß mithilfe dieses Rakels lediglich noch in eine Druckrichtung gedruckt werden muß, da immer ein entsprechender Rakelteil sowohl vor als auch hinter der Unebenheit auf der Trägerplatte aufliegt.

Rein prinzipiell sind die unterschiedlichsten Anordnungen der Schlitze in dem Rakel denkbar. So könnten beispielsweise die Schlitze immer in einem konstanten Abstand voneinander in dem Rakel angeordnet sein.

Von besonders großem Vorteil ist es jedoch, wenn der Abstand der Schlitze jeweils auf die Lage und Breite der auf der Trägerplatte angeordneten Unebenheiten angepaßt ist. Auf diese Weise wird ein besonders präziser Materialauftrag auf der Trägerplatte erreicht.

Als Werkstoff für das Rakel würden sich des weiteren prinzipiell die unterschiedlichsten Materialien eignen.

Insbesondere im Hinblick auf eine besonders gute Elastizität besteht das Rakel jedoch aus Kupferbronze. Kupferbronze hat zum einen als Lagermetall außerordentlich gute Gleiteigenschaften, zum anderen weist es eine Elastizität auf, die ein Federn der Rakelteile ermöglicht, ohne daß diese verbiegen.

Darüber hinaus kann das Rakel aber auch aus Gummi bestehen.

Weitere Merkmale und Vorteile der Erfindung sind Gegenstand der nachfolgenden Beschreibung sowie der zeichnerischen Darstellung einiger Ausführungsbeispiele.

In der Zeichnung zeigen:
- Fig. 1: schematisch die Vorderansicht eines erfindungsgemäßen Rakels;
- Fig. 2: schematisch eine Druckvorrichtung, welche ein erfindungsgemäßes Rakel verwendet und
- Fig. 3: die in Fig. 2 dargestellte Druckvorrichtung beim Druckvorgang.

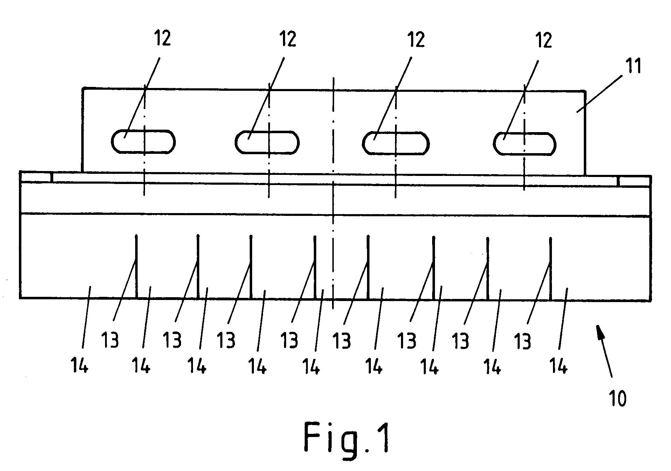

Ein Ausführungsbeispiel eines Rakels 10, dargestellt in Fig. 1, umfaßt eine Rakelhalterung 11, in welcher Langlöcher 12 zur Befestigung des Rakels angeordnet sind.

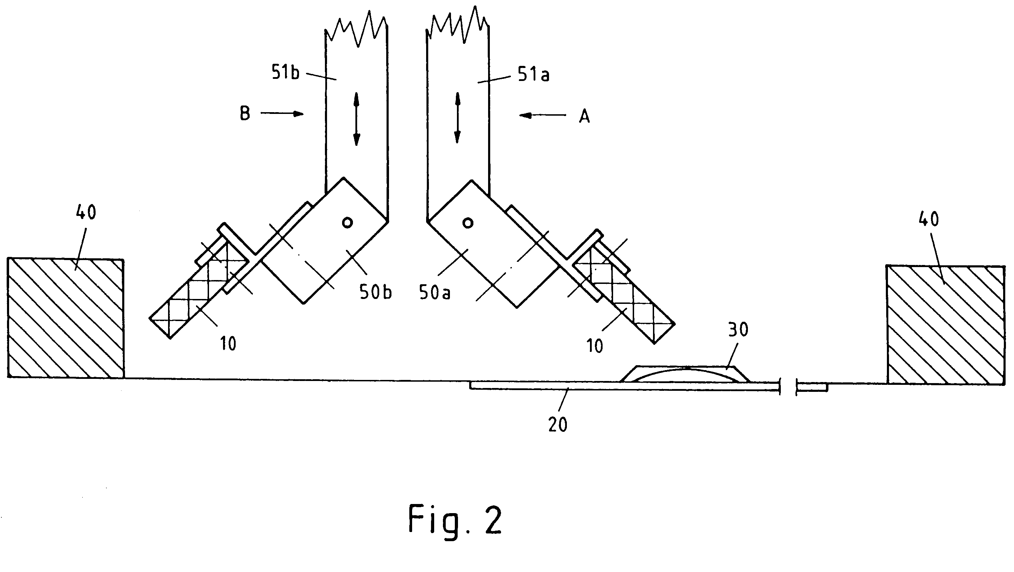

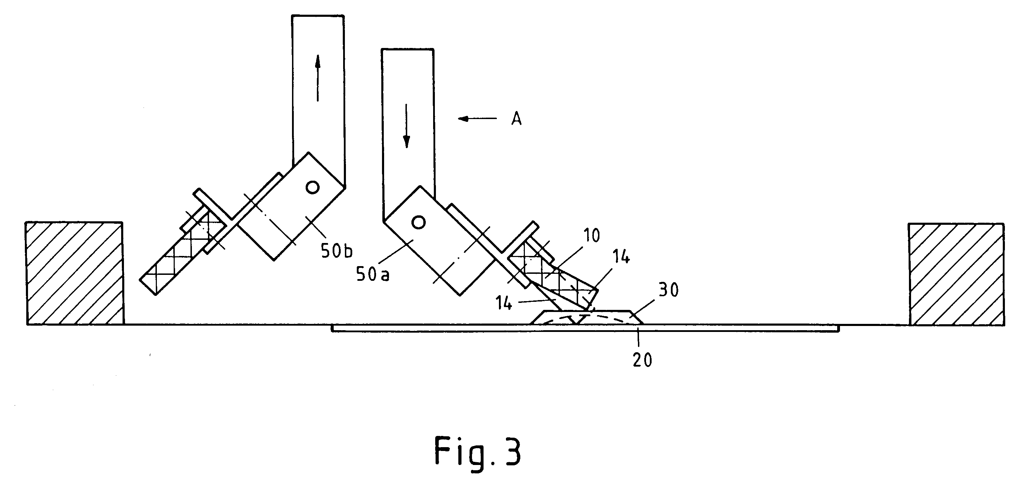

Auf der unteren, der Trägerplatte (siehe Fig. 2 und Fig. 3) zugewandten Seite, weist das Rakel 10 mehrere Schlitze 13 auf, deren Abstand voneinander jeweils auf die Lage und Breite der auf der Trägerplatte 20 angeordneten Unebenheiten 30 (vergl. Fig. 2 und Fig. 3) angepaßt ist.

Durch diese Schlitze 13 ist das Rakel 10 mit anderen Worten in unterschiedliche Rakelteile 14 aufgeteilt, deren durch den Abstand der Schlitze 13 voneinander bestimmte Breite auf die auf der Trägerplatte 20 angeordneten Unebenheiten 30 angepaßt ist, daß beispielsweise die Breite einzelner Rakelteile 14 im wesentlichen dem Abstand und der Breite der Unebenheiten 30 auf der Trägerplatte 20 senkrecht zur Bewegungsrichtung des Rakels beim Druckvorgang entspricht. Auf diese Weise können sowohl zwischen als auch vor und hinter den einzelnen Unebenheiten 30, Widerstandselemente u.dgl. mittels Siebdrucktechnik auf die Trägerplatte 20 aufgebracht werden.

In Fig. 2 ist schematisch eine Druckvorrichtung dargestellt, in der ein Rakel 10 der oben beschriebenen Art verwendet werden kann.

Wie aus Fig. 2 hervorgeht, ist ein Rahmen 40 vorgesehen, innerhalb dessen die Trägerplatte 20 angeordnet ist. Auf der Trägerplatte 20 sind Bauelemente u.dgl., die in früheren Schritten auf der Trägerplatte angeordnet werden, durch Metallmasken überdeckt, welche beim Druckvorgang die Unebenheiten 30 bilden. Die Rakel 10 sind an Halterungen 50a, 50b befestigt, die ihrerseits mit Zylindern 51a, 51b verbunden sind. Durch die Zylinder 51a, 51b sind die Rakel 10 auf und ab, d.h. zur Trägerplatte 20 hin und von dieser wegbewegbar, wie es durch die Doppelpfeile angedeutet ist.

Die Anordnung aus Zylinder 51b, Halterung 50b und Rakel 10 dient dabei zum Druck in eine mit einem Pfeil B bezeichnete Richtung (in Fig. 2 und 3 von links nach rechts), wohingegen Zylinder 51a, Halter 50a und Rakel 10 dem Druck in die dazu entgegengesetzte, mit einem Pfeil A bezeichnete Richtung (in Fig. 2 und 3 von rechts nach links) dient.

Der Betrieb der in Fig. 2 dargestellten Druckvorrichtung ist in Fig. 3 schematisch dargestellt.

Wie aus Fig. 3 hervorgeht, ist das Rakel 10 beim Druckvorgang durch den Zylinder 51a auf die Trägerplatte 20 abgesenkt und wird gleichzeitig über die Trägerplatte 20 in Richtung des Pfeils A geführt. Dabei liegt das Rakel 10, d.h. sämtliche Rakelteile 14, auf der Trägerplatte 20 auf und trägt so das aufzudruckende Material, beispielsweise eine Lötpaste, auf die Trägerplatte 20 auf. Sobald das Rakel 10 eine Unebenheit 30, d.h. ein Hindernis, z.B. durch eine Metallmaske abgedeckte, in einem früheren Schritt auf die Trägerplatte 20 aufgebrachte Bauelemente überstreicht, wird der Rakelteil 14, der sich über der Unebenheit 30 befindet, beim Überqueren der Unebenheit 30 durch diese von der Trägerplatte 20 weggeschwenkt, wohingegen der zu diesem Rakelteil 14 benachbarte, von der Unebenheit 30 nicht beeinflußte Rakelteil 14 weiterhin auf der Trägerplatte 20 aufliegt und die Lötpaste auf die Leiterplatte 20 aufträgt. Sobald der Rakelteil 14 die Unebenheit 30 überquert hat, schwenkt er aufgrund seiner Elastizität wieder auf die Trägerplatte 20 zurück und trägt hinter der Unebenheit 30 ebenfalls Lötpaste auf die Trägerplatte 20 auf.

Durch die oben beschriebene Schlitzung des Rakels 10 wird somit eine Flächenbedruckung der Trägerplatte 20 ermöglicht, wobei Unebenheiten 30 auf der Trägerplatte 20 durch das Hochschwenken des die Unebenheit 30 überquerenden Rakelteils 14 gezielt ausgespart werden können.

Von besonders großem Vorteil ist es, daß ein derartig geschlitztes Rakel 10 bei entsprechender Anordnung der Schlitze 13 bei Trägerplatten mit unterschiedlich angeordneten Unebenheiten 30 verwendet werden kann und ein Druckvorgang nur in eine Druckrichtung erfolgen muß.

Das Rakel 10 selbst besteht aus Kupferbronze, welche einerseits ausgezeichnete Gleiteigenschaften, andererseits auch eine hohe Elastizität aufweist. Es kann aber auch aus Gummi bestehen.

## Patentansprüche

1. Rakel für den Siebdruck von elektrischen Elementen und Strukturen auf einer Trägerplatte mit Unebenheiten, **dadurch gekennzeichnet**, daß das Rakel (10) elastisch ausgebildet ist und auf seiner der Trägerplatte (20) zugewandten Seite einen oder mehrere Schlitze (13) zur Teilung des Rakels (10) in mehrere Rakelteile (14) aufweist.

2. Rakel nach Anspruch 1, dadurch gekennzeichnet, daß der Abstand der Schlitze (13) voneinander jeweils auf die Lage und Breite der auf die Trägerplatte (20) angeordneten Unebenheiten (30) angepaßt ist.

3. Rakel nach Anspruch 1 oder 2, dadurch gekennzeichnet, daß das Rakel (10) aus Kupferbronze besteht.

4. Rakel nach Anspruch 1 oder 2, dadurch gekennzeichnet, daß das Rakel aus Gummi besteht.
